# EUROPEAN PATENT APPLICATION

(11) **EP 4 560 326 A1**
(43) Date of publication of application: **28.05.2025**
(21) Application number: 24215583.6
(22) Date of filing: 26.11.2024
(51) Int. Cl.: G01R 15/20

(54) **ELECTRIC CURRENT SENSOR**

(30) Priority: 27.11.2023 GB 202318052
(71) Applicant: Fortescue Zero Limited, Kidlington Oxfordshire OX5 1GB (GB)
(72) Inventor: SPRENGER, Jake, Etobicoke, M9C 1X3 (CA)
(74) Representative: Boult Wade Tennant LLP

(57) **Abstract**

There is described an electrically powered vehicle comprising: an electrical conductor arranged to carry motive electric current for powering movement of the vehicle; and a current sensor arranged to measure the motive electric current in the electrical conductor, the current sensor comprising: a carrier extending around the conductor so as to be in confrontation with opposing faces of the electrical conductor; first and second hall sensor packages mounted on the carrier at the opposing faces of the conductor, each hall sensor package being arranged to output a signal representative of a magnetic field at the package; a differential amplifier mounted on the carrier to receive the signals from the first and second hall sensor packages and to combine the signals to provide at least one amplifier output representing the motive electrical current. The carrier may comprise a flexible PCB. There is also described a method of measuring electric current.

## Description

The invention relates to the measurement of electric current in a conductor, for example the measurement of motive electric current within a powertrain of an electric vehicle.

### Introduction

An electric vehicle typically uses a plurality of electrical conductors to carry motive electric current through a powertrain from cells of one or more batteries or another electrical power source such as a fuel cells, to one or more electric motors which drive wheels or other drive elements of the vehicle. The peak currents may be large, for example often being in a range of about 10 to 1000 Amps, and the cross sectional areas of the electrical conductors may be correspondingly large, for example often being in a range from about 10 mm² to about 2000 mm². Accurate control of the powertrain may require accurate measurements to be made of the motive electric current within these electrical conductors.

Various other situations also require accurate measurement of large electric currents within conductors, for example within industrial installations such as factory production lines, chemical plants, and mining equipment; power production facilities such as solar arrays, wind turbines, gas turbine based power plants, and other generation facilities as well as in electrical grid power transmission arrangements; and in variety of different vehicle types such as road vehicles, industrial vehicles, railway engines, ships and aircraft.

Various prior art arrangements exist for such electric current measurements. An HFTS series current sensor manufactured by LEM Holding SA uses a ferrite ring flux concentrator which encircles the electrical conductor, and a hall effect sensor located at a gap within the flux concentrator ring, but is physically large, challenging to install on an in-situ conductor, and is sensitive to background magnetic fields. An IMC-Hall current sensor as manufactured by Melexis N.V. can more readily be installed on an in-situ conductor, but requires the use of a bulky magnetic shield to reduce sensitivity to background magnetic fields and to concentrate the field to be measured.

It would be desirable to address limitations of the related prior art.

### Summary of the invention

The invention provides a current sensor arranged to measure electric current in an electrical conductor, the current sensor comprising: a carrier extending around the conductor so as to be in confrontation with both of two opposing faces or opposing points around the conductor; separate first and second hall effect sensors or hall sensor packages or components mounted on the carrier at the opposing faces or points of or around the conductor, each hall sensor being arranged to output a signal representative of a magnetic field at the respective sensor; and an amplifier or comparator, or more particularly a differential amplifier, which is also preferably mounted on the carrier, the amplifier or comparator being arranged to receive the signals from the first and second hall sensor packages and to combine the signals to provide at least one amplifier output representing the electric current within the conductor compensated to remove any background magnetic field common to the two hall effect sensors.

More particularly, the current sensor may comprise: a flexible carrier having first and second regions, the flexible carrier being arranged to extend around the electrical conductor so that the first and second regions are in confrontation with respective opposing faces of the conductor; first and second hall sensor packages or components mounted on the carrier in the respective first and second regions, each hall sensor package being arranged to output a signal representative of a magnetic field at that hall sensor package; and a differential amplifier mounted on the carrier, the differential amplifier being arranged to receive the signals from the first and second hall sensor packages and to differentially combine the signals to provide at least one amplifier output representing the electric current in the conductor.

The invention may particularly be applied to the measurement of motive electric current in an electrically powered vehicle, and therefore to an electric vehicle comprising: an electrical conductor arranged to carry motive electric current for powering movement of the vehicle, the electrical conductor having opposing faces; and a current sensor arranged to measure the motive electric current in the electrical conductor. The current sensor then comprises: a carrier extending around the conductor so as to be in confrontation with both of the opposing faces; first and second hall sensor packages mounted on the carrier at the opposing faces of the conductor, each hall sensor package being arranged to output a signal representative of a magnetic field at the package; a differential amplifier preferably also mounted on the carrier, the differential amplifier being arranged to receive the signals from the first and second hall sensor packages and to differentially combine the signals to provide at least one amplifier output representing the motive electric current.

The invention also provides such an electrically powered vehicle which is arranged to control the motive electric current responsive to the at least one amplifier output.

The carrier may comprise a flexible PCB, and the first and second hall sensor packages and the differential amplifier may then be mounted on, and in electrical communication with each other via conductive tracks of, the flexible PCB.

The carrier may further comprise at least first and second stiffener elements, each stiffener element being disposed between a respective one of the faces of the conductor and an adjacent portion of the flexible PCB. Such stiffener elements can help to retain the hall sensor packages in a stable position relative to, and close to, the conductor.

Each hall sensor package may be arranged to detect the magnetic field parallel to the adjacent face of the conductor which is caused by the motive current flowing in the conductor. By adding the output signals of the hall sensors vectorially using the differential amplifier, the magnetic fields due to the current in the conductor are added, and any background magnetic field common to both packages are subtracted and therefore removed from the amplifier output.

The first and second hall sensor packages may be mounted on respective first and second planar regions of the carrier, and the first and second planar regions may be coupled by a bend region of the carrier enabling each planar region to be located adjacent to an opposite face of the conductor.

The carrier may further comprise a connection region extending from one of the first and second planar regions, and an electrical connector mounted on a distal end of the connection region, the connection region carrying the at least one amplifier output to the electrical connector for output from the sensor.

The electrical conductor may have a cross sectional area, at least at the location of the current sensor, of from about 10 mm² to about 2000 mm², or more particularly from about 50 mm² to about 1000 mm². The electrical conductor may have a cross section aspect ratio, at least at the location of the current sensor, of between 2 and 20, i.e. the opposing faces each have a length which is between 2 and 20 times the spacing between these opposing faces.

The described sensor is beneficial in that current in the conductor can be measured without needing to provide, and without providing, any aperture through the electrical conductor at the location of the sensor, for example between the portions of the carrier extending around the conductor, or between the first and second hall sensor packages. The sensor can therefore be used on any unmodified portion of the conductor which is reasonably accessible.

The described sensor is also beneficial in not requiring, and indeed without providing, any magnetic flux concentrator component (such as a ferrite structure) adjacent to the electrical conductor in the vicinity of the hall sensor packages, for example not within 2 cm of each hall sensor package.

In other terms, the invention may also be described as providing a current sensor for measuring electric current in an electrical conductor having opposing faces, the current sensor comprising: a flexible carrier having first and second regions, the flexible carrier being arranged to extend around the conductor so that the first and second regions are in confrontation with the respective opposing faces; first and second hall sensor packages or components mounted on the carrier in the respective first and second regions, each hall sensor package being arranged to output a signal representative of a magnetic field at that hall sensor package; and a differential amplifier mounted on the carrier, the differential amplifier being arranged to receive the signals from the first and second hall sensor packages and to combine the signals to provide at least one amplifier output representing the electric current.

The flexible carrier may then further comprise one or more of a bend region connecting the first and second planar regions, and a connection region connecting the first or the second planar region to an electrical connector. The electrical connector is then arranged to output from the sensor the at least one amplifier output representing the electrical current in the conductor.

The flexible carrier may comprise a flexible printed circuit board, which we refer to as a flexible PCB, and the first and second hall sensor packages, the differential amplifier, and the electrical connector may then all be mounted on the flexible PCB in electrical communication as required via tracks of the flexible PCB.

The flexible carrier may comprise stiffener elements coupled to the flexible PCB in each of the first and second planar regions.

The invention also provides methods of constructing or manufacturing the described sensor, and methods of using the sensor as described herein, including mounting the sensor on a conductor and/or measuring electric current using the sensor. For example, the invention provides a method of measuring the electric current in an electrical conductor having opposing faces, the method comprising: bending or wrapping a flexible carrier on which separate first and second hall sensor packages or components are mounted around the conductor so that each hall sensor package is adjacent to a different one of the opposing faces and provides an output signal representing the local magnetic field arising from the electric current; receiving the output signals at a differential amplifier mounted on the carrier, the differential amplifier being arranged to combine the output signals to generate at least one amplifier output which represents the electric current compensated to remove the effect of background magnetic field common to the two hall sensor packages; and outputting the amplifier output from the sensor.

As noted above, the flexible carrier may comprise a flexible PCB on which the hall sensor packages and optionally also the differential amplifier are mounted. As for the described apparatus, the electrical conductor may be a conductor carrying motive electric current within the powertrain of an electric vehicle.

### Brief summary of the drawings

Embodiments of the invention will now be described, by way of example only, with reference to the drawings of which:
Figure 1 illustrates an electric vehicle in which one or more current sensors embodying the invention are deployed and operated;
Figure 2 shows in schematic cross sectional view a current sensor arranged for measuring the electric current in a conductor, for example in the context of the electric vehicle of figure 1;
Figure 3 provides a schematic diagram of electronic circuitry which may be used as part of and external to a current sensor of figure 1 or 2;
Figure 4 shows an embodiment of the current sensor of figure 2 or 3 in side/cross sectional view, before it has been deployed by mounting on a conductor for current measurement;
Figure 5 shows a detailed embodiment of the current sensor of any of figures 2 - 4 in perspective view; and
Figure 6 shows steps of a method of deploying and/or operating the current sensor of any of figures 2 to 5.

### Detailed description of embodiments

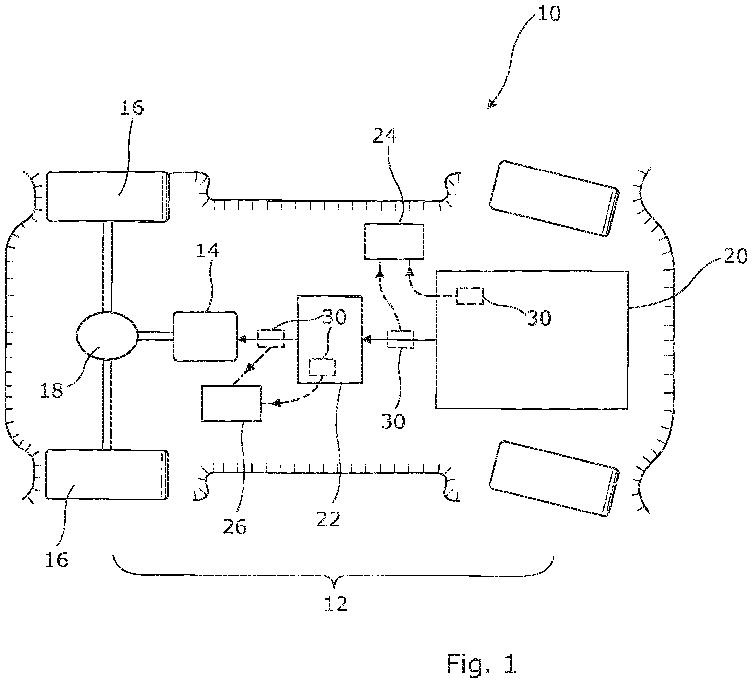

Figure 1 illustrates an electric vehicle 10 schematically in plan view. The electric vehicle 10 comprises a powertrain 12 which includes one or more electric motors 14 for driving wheels 16 or other drive elements of the vehicle, optionally via mechanical gearing 18, and one or more batteries 20 for providing motive electric current for use by the motors 14. In order to condition the motive electric current for delivery to the one or more motors 14 in the correct form, the powertrain 12 also comprises power electronics 22 which may itself comprise one or more DC-DC converters, DC-AC inverters, and other elements.

Various electronic systems may be provided within, and optionally at least partly externally to the electric vehicle 10, in order to provide appropriate monitoring and/or control of the powertrain, for example a battery management system 24 and a powertrain electronic control unit 26. Such electronics systems may benefit from having accurate measurements of the motive electric current at various points within the powertrain, anywhere from within the one or more batteries 20 through to the one or more electric motors 14. To this end, the electric vehicle 10 comprises one or more current sensors 30 arranged to measure the motive electric current flowing within electrical conductors forming part of the powertrain 12, and these current sensors 30 may then provide measurements of the motive current to any or all of the electronics systems such as the battery management system 24 and the powertrain electronic control unit 26.

Note that other embodiments may relate to the described current sensors 30 as such, whether installed proximally to an electrical conductor or not yet so installed, or to such current sensors used, or for use, in a variety of other application areas to measure electric current within an electrical conductor, for example within an electric conductor as more particularly described below. Such other application areas may include factory production lines, chemical plants, and mining equipment; power production facilities such as solar arrays, wind turbines, gas turbine based power plants, and other generation facilities as well as in electrical grid power transmission arrangements; and in a variety of different vehicle types such as road vehicles, industrial vehicles, railway engines, ships and aircraft.

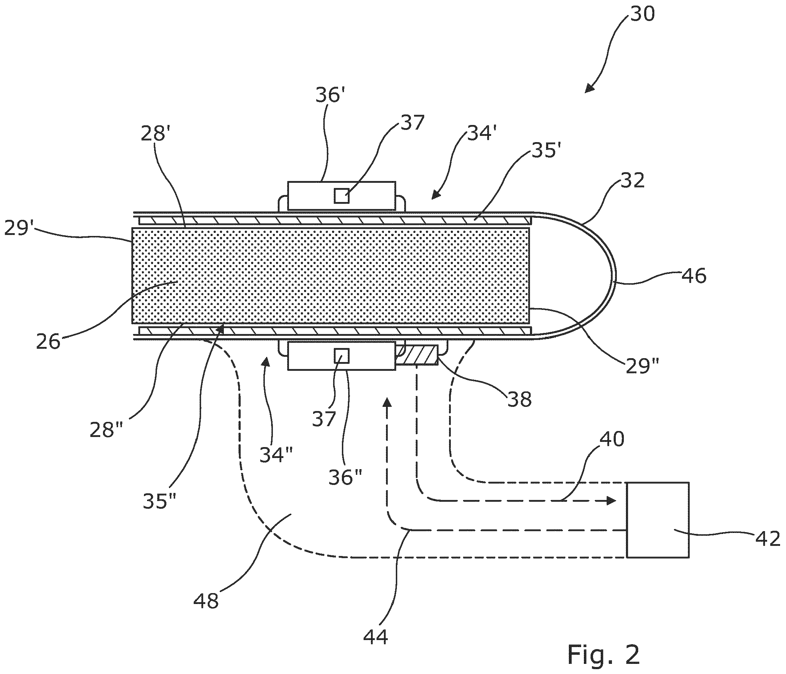

Figure 2 illustrates, in schematic and quasi-cross sectional view, a current sensor 30 that can be used as shown in the electric vehicle of figure 1, or indeed in various other situations where it is wished to measure electric current within an electrical conductor. The current sensor 30 is used to measure the electrical current flowing within an electrical conductor 26 which, in the context of figure 1 is motive electrical current within an electrical conductor forming part of the powertrain 12. At least at the location where the current sensor 30 is positioned, the electrical conductor has opposing and typically parallel, typically planar, major faces 28', 28". The electrical conductor may for example be of substantially rectangular cross section, or could have opposing planar major faces and opposing curved minor faces, or some other construction or cross section. The invention may also be used in respect of conductors with other cross section shapes such as round, oval or other more complex forms, in which case when we refer to opposing faces it may be understood that opposing points around the conductor are meant.

In a typical vehicle powertrain 12 the electrical conductor 26, at least where the current sensor is positioned, might typically have a cross sectional area of from about 10 mm² to 2000 mm², or from about 50 mm² to about 1000 mm². A typical cross sectional aspect ratio (width to height as shown in the cross section of figure 2) could be from about 2 to about 20, or from about 4 to about 10, such that the major faces 28', 28" shown in figure 2 are longer in the cross section than the minor faces 29', 29" by this aspect ratio.

The electrical conductor may typically be formed of copper, aluminium, or some other suitable metal or combination of such metals and optionally also or instead of other materials, and may comprise an insulating cover layer for example formed of a plastic material. The electrical conductor could be designed to carry peak electrical currents from about 1 to 10,000 Amps, or from about 10 to 1000 Amps, depending on the vehicle and powertrain design, or other area of application, and the function of the electrical conductor within that design

The current sensor 30 as illustrated in figure 2 comprises a carrier 32 which extends around the conductor 26 so as to comprise a first region 34' (described hereafter as a first planar region since it will typically be approximately flat so as to conform to the underlying surface of the conductor) at least partly in confrontation with one of the opposing major faces 28' of the conductor, and a second region 34" (described hereafter as a second planar region for equivalent reasons) at least partly in confrontation with the other opposing major face 28". For example, the first and second planar regions of the carrier 32 may each extend at least 60% and more preferably 80% across the width of each respective major face. In figure 2 the first and second planar regions each extend approximately 100% across each major face.

The carrier 32 may therefore be said to wrap around the conductor 26, although typically and as shown in figure 2 the carrier will extend or wrap around one minor face 29" of the conductor, but not around the other minor face 29'. In this way the carrier 32 may be described as having a U-shape in cross section, with the electrical conductor located at least partly within the U-shape. The first and second planar regions 34', 34" of the carrier 32 in confrontation with opposing faces of the conductor are then coupled by a bend region 46 of the carrier, where the carrier has a suitable radius of curvature.

The carrier may also comprise a connection region 48 which extends away from the conductor when installed as shown in figure 2, for example extending away from one of the first and second planar regions 34', 34" (shown as extending away from the second planar region 34" in figure 2) so as to provide connectivity between the sensor 30 and external electronics, for example via an electrical connector 42 or plug.

When installed as shown in figure 2, either or both of the first and second planar regions 34', 34" of the carrier 32 may be in direct contact with the respective major faces 28', 28" of the conductor, or may be separated at either one or both major faces, for example by one or more of an air gap, a spacing structure or material, or a stiffener element 35', 35" as described further below.

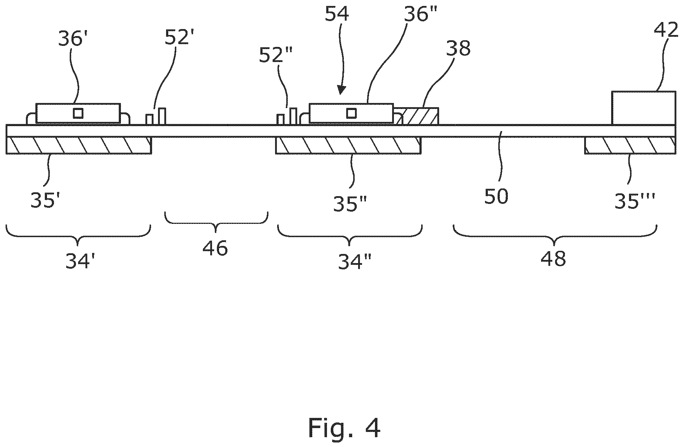

The carrier 32 may be provided as an integral, rigid structure constructed in a final, rigid form which is arranged to fit around the conductor as shown in figure 2. However, in the interest of more flexible and convenient installation, the carrier may be constructed as a single and/or continuous and/or planar, flexible component. Such a component is preferably sufficiently flexible to be constructed or manufactured in a flat, open configuration (see figure 4) for subsequent bending or wrapping around the conductor as illustrated in figure 2. To this end the carrier may have a thickness of less than 2mm, or less than 1 mm. In particular, and as discussed below, if provided as a flexible, continuous component, the carrier may be implemented using, or comprise, a flexible printed circuit board (PCB).

Especially if implemented as a flexible, continuous component, the carrier may be secured to the conductor using a suitable clip (not shown in the figure), for example a clip holding the first and second planar regions against the opposing major faces of the conductor, by a binding such as a shrink wrap binding around the whole of the first and second planar regions and the contained portion of the conductor, or in various other ways.

In order to measure the motive electric current flowing within the conductor 26, the current sensor 30 comprises separate first and second hall sensor packages or components 36', 36" which are mounted on the carrier at the first and second planar regions 34', 34", so proximally or adjacent to the respective opposing major faces 28', 28" as shown in figure 2. Each hall sensor package 36', 36" may preferably be located centrally with respect to the respective adjacent face of the conductor, for example with a central point or a hall effect region 37 of each sensor package being located between 40% and 60% across the width of the conductor. Each hall sensor package 36', 36" may preferably be located quite close to the adjacent face of the conductor, for example with a central point or a hall effect region 37 of each sensor package being located between 1 mm and either 10 mm or 20 mm from the surface of the conductor.

Each hall sensor package 36', 36" measures magnetic field at the respective package using the hall effect, and therefore provides an electrical output signal representing magnetic field proximally or adjacent to a respective opposing face of the conductor. Each hall sensor package is a separate semiconductor package, and may each typically be implemented as a dual inline package (DIL or DIP). MLX 91216 hall sensor packages produced by Melexis N.V. are an example of hall sensor packages suitable for the present purposes.

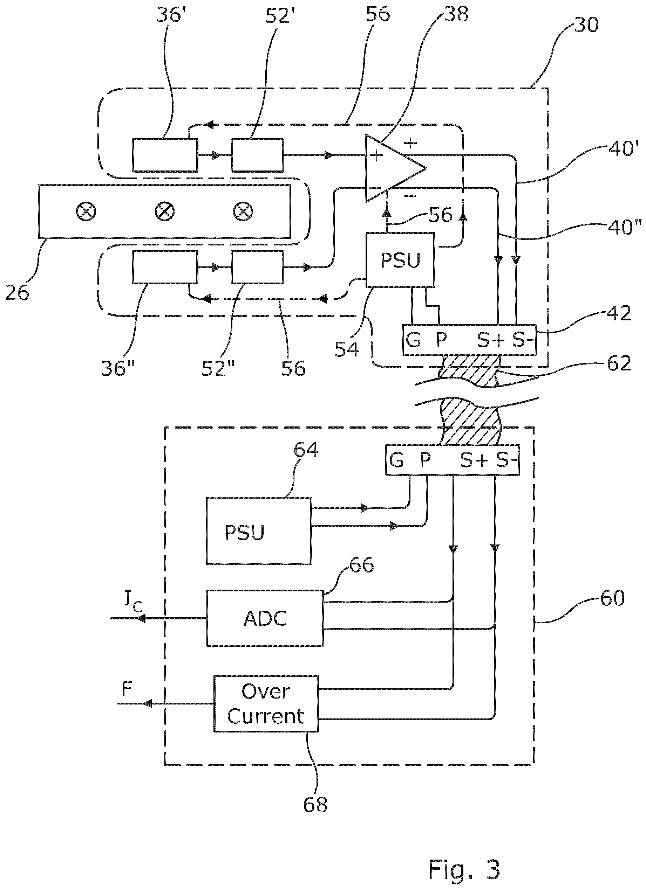

The electrical outputs of the two hall sensor packages 36', 36" are received at a differential amplifier 38 which is preferably also mounted on the carrier (although may be provided elsewhere for example in the external electronics seen in figure 3). The differential amplifier 38 is partially visible in figure 2, mounted near to the hall sensor package 36" in the second planar region 34" of the carrier 32. The differential amplifier is typically provided as a further separate semiconductor package, mounted separately on the carrier to the two hall sensor packages, and may be provided as a fully differential operational amplifier such as an Analog Devices LTC6363 amplifier. Other electronics components may also be mounted on the carrier as discussed below in connection with figure 3.

The differential amplifier 38 is arranged to combine the output signals from the two hall sensor packages 36', 36" to provide an amplifier output 40 which represents magnetic field adjacent to the conductor, but with the effect of longer range background magnetic fields common to both hall sensor packages which are not caused by this electrical current having been removed by the differential action of the amplifier 38. The amplifier output 40 may therefore be used as an accurate measure or representation of the electric current flowing within the conductor.

With electric current flowing along the conductor in a particular direction, the resulting magnetic field lines encircle the conductor, so that the vector magnetic field ***B*** at one hall sensor package resulting from the current to be measured is in the opposite direction to that at the other hall sensor package - ***B*** (if both magnetic fields are represented in the same cartesian coordinate system). If both also contain the same, common background or noise magnetic field vector element **N,** then the signals measured at each hall sensor package are ***B* + *N*** and **- *B* + *N,*** so that subtracting the two measurements in this sense at the differential amplifier to provide a differential output provides a measure of the magnetic field as ***± 2B*** with the common background ***N*** removed. Since the measured magnetic field ***± 2B*** represented by the amplifier output 40 is proportional to the current in the conductor, the electrical current can be derived as a simple linear multiple of this magnetic field.

The amplifier output 40 may be delivered along the carrier 32, for example along the connection region 48 of the carrier to the electrical connector 42 from where it can be delivered on to electronic systems of the vehicle such as the battery management system 24 and powertrain electronic control unit 26 for further use as described above, for example to control aspects of the powertrain 12 such as to provide control of the current in the conductor 26. In practice, the amplifier output 40 may itself be provided by the differential amplifier as two output signals, often referred to as differential outputs. Such differential outputs are essentially two versions of the same signal which are equal in magnitude but opposite in polarity, and are readily provided by a fully differential operational amplifier such as the Analog Devices LTC6363 amplifier mentioned above. Combining these differential outputs together at a distant point such as the analogue to digital converter 66 of figure 3 reduces or removes common mode noise influencing the signals during transit to that point.

Typically the amplifier output 40 may be digitised using an analogue to digital converter. This may take place within the sensor 30 as illustrated in figure 2, but more typically will take place elsewhere following export of the differential output 40 via the connector 42. Other signals and electrical connections may be provided via the electrical connector 42, for example a power supply 44 for operation of the hall sensor packages, differential amplifier, and other aspects of the current sensor 30.

Figure 3 illustrates schematically how the amplifier output 40 may be formed from the output signals of the two hall sensor packages mounted on the carrier 32 (to aid clarity, the carrier is not shown in this figure), and how the amplifier output may be subsequently processed and passed on to other electronics systems. The two hall sensor packages 36', 36" are depicted as located adjacent to respective opposing faces 28', 28" of electrical conductor 26 within which the current to be measured is depicted as flowing into the page. The output signal from each hall sensor package is delivered to conditioning electronics also mounted on the carrier 32 (not shown) such as respective de-noise filters 52', 52", from which the conditioned output signals are delivered as differential inputs + and - to differential amplifier 38, typically provided by an operational amplifier package. The amplifier output 40 then represents a voltage difference between the signals from the hall sensor package signals, and as shown in figure 3 this may be provided as differential outputs 40', 40" (also labelled + and -) which are delivered to electrical connector 42 (where they are shown as **S+** and **S-**).

The sensor may also comprise a local power supply 54 which comprises one or more electronics components mounted on the carrier, and which receives power from the electrical connector 42 (shown here as a ground **G** and a power **P** connection which could be for example +10 V relative to the ground), and delivers conditioned power 56 to each of the hall sensor packages and the differential amplifier. Although not shown in figure 3, the local power supply 54 may also deliver positive and negative reference voltages to the electrical connector 42 for use in more stable measurement of the current in the conductor 26 by the connected electronics 60 described below.

The connected electronics 60 depicted in figure 3 is connected to the sensor 30 via a cable 62 coupling to the electronics connector 42, and comprises an external power supply 64 for delivering the ground ***G*** and power ***P*** connections to the sensor 30, and for receiving the differential amplifier outputs 40', 40", and optionally also the positive and negative reference voltages if provided by the sensor's local power supply 54. These outputs are forwarded to an analogue to digital converter 66 which provides a digital output ***I_{c}*** representing the current in the conductor 26, and to a separate overcurrent detector 68 which is separately arranged to detect if the current in the conductor 26 exceeds a threshold, and if so then outputs an overcurrent flag ***F*.** The overcurrent flag ***F*** may be used by other electronics systems in various ways, for example to shut down the current in the conductor if it exceeds a safe level.

As already mentioned above, the carrier 32 may in particular comprise or be provided by a flexible PCB, and the hall sensor packages, optionally the differential amplifier, and optionally other components such as those forming the local power supply 54 and de-noise filters 52', 52" may then be mounted on, and in electrical communication with each other and the electrical connector 42 as needed via conducting tracks of the flexible PCB.

Especially if provided as a flexible and continuous element, the carrier may further comprise separate stiffener elements 35', 35" in each of the first and second planar regions 34', 34" where the carrier is in confrontation with a major face 28', 28" of the conductor. In particular, if the carrier comprises a flexible PCB then each such stiffener element may be coupled or bonded to corresponding the first and second planar regions 34', 34" of the flexible PCB which are in confrontation with the major faces of the conductor. These stiffener elements 35', 35" may be formed of an insulator such as polyimide, and may serve both to provide enhanced electrical insulation between the flexible PCB and the conductor, and to improve the stiffness of the flexible carrier in the regions of confrontation so that the carrier in these regions is held in more stable conformation with the conductor in these regions. Providing such stiffener elements 35', 35" only where the carrier is held in confrontation with the opposing faces of the conductor, and optionally in limited other regions where enhanced stiffness is required such as proximally to the electrical connector 42, enables the carrier to more readily bend in bend region 46, and in connection region 48.

Figure 4 illustrates in schematic and cross sectional view (dimensions and sizes not shown in proportion) how the sensor 30 of figure 2 may be provided using the carrier 32 discussed above provided in a flexible, planar and continuous form, for example using a flexible PCB 50 with suitable stiffener elements 35', 35", 35‴ as mentioned above. In figure 4 the carrier 32 is shown in an open, flat form, before being deployed by bending or wrapping around a conductor as depicted in figure 2. The flexible PCB 50 may typically be formed of polyimide or another suitable material, with the addition of electrically conducting tracks, further insulating layers and so forth as typical of a flexible PCB, and with a thickness of around 0.1 - 1.0 mm, or more typically about 0.2 mm. The hall sensor packages 36', 36" are then mounted to the flexible PCB 50 at appropriate locations within the planar regions 34', 34" such that these are proximal the two opposing faces of the conductor once the sensor has been wrapped around the conductor for example as described above in connection with figure 2.

The stiffener elements 35', 35", which may also be formed of polyimide or another suitable material, and which may have a thickness of around 0.1 -1.0 mm or more typically about 0.25 mm, are then also provided adjacent to and on the opposite side of the flexible PCB 50 from the hall sensor packages 36', 36", in the first and second planar regions 34', 34" which are intended to be adjacent to the first and second major faces 28', 28" of the conductor. These stiffener elements 35', 35" then assist in maintaining the hall sensor packages in a stable position relative to the conductor, and may also assist in ensuring that the adjacent circuitry components are held stably and reliably in place, as well as providing additional electrical insulation between the conductor and the electronics components of the sensor disposed on the carrier.

The bend region 46 of the flexible PCB 50 does not comprise any stiffener element, so as to better enable the carrier 32 to wrap around from one face of the conductor to the other. Similarly, most of the connection region 48 does not comprise any stiffener element so as to maintain the flexibility of the connection region 48 in the interests of flexible and easy installation of the sensor, but an end portion of the connection region 48 may be provided with a further stiffener element 35‴ proximally to the electrical connector 42 to improve reliability of that connection.

Other electronics components such as the differential amplifier 38, local power supply 54 and de-noise filters 52', 52" are also mounted to the flexible PCB, preferably in regions of the flexible PCB where the stiffeners are also provided.

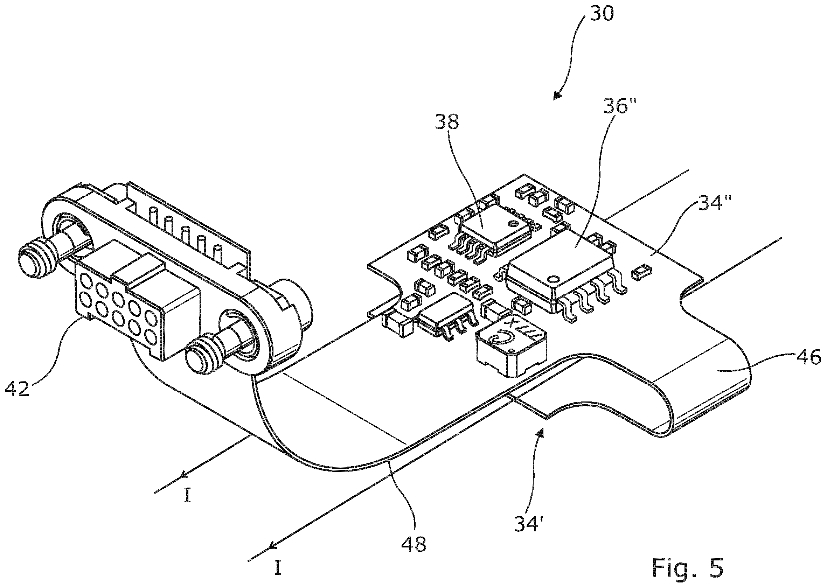

Figure 5 depicts a version of sensor 30 of the previous figures in perspective view, and in particular shows how the first planar region 34', the bend region 46, the second planar region 34" and the connection region 48 may be geometrically related and disposed when the sensor is in a deployed configuration wrapped around an electrical conductor for measuring the current flowing in the sensor. For clarity the electrical conductor is omitted in this figure, but the two long arrows labelled *I* show a current within such a conductor which may be measured by the sensor. The second hall sensor package 36", the differential amplifier 38, and other electronics components may also be seen.

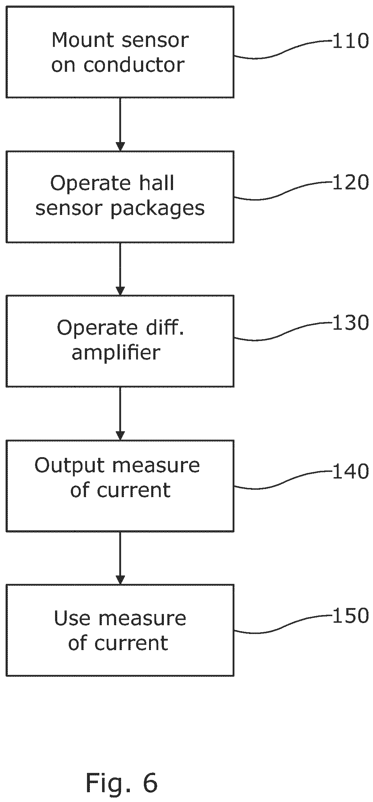

The invention also provides various methods of manufacturing and of using a sensor as described above. For example, figure 6 illustrates a method of measuring the electric current in an electrical conductor having properties such as those discussed above, and using a sensor as described above.

In step 110 of the method, the carrier of the sensor is deployed by mounting on the conductor. If the carrier is a flexible carrier for example comprising a flexible PCB as discussed above, with or without the described stiffener elements, then this may involve bending or wrapping the carrier into a U-shape around the conductor so that each hall sensor package mounted on the carrier is adjacent to a different one of the opposing major faces of, or at opposite points of, the conductor surface.

The method proceeds at step 120 by operating the sensor so that each hall sensor package provides an output signal representing the local magnetic field at the package, which in turn represents the electrical current within the conductor subject to any background magnetic field from other sources. This step may involve for example ensuring that the sensor is connected to a suitable power supply, for example to external power supply 64 of figure 3 via the cable 62 and electrical connector 42, and that any control signals are provided as required.

At step 130 the output signals of both of the hall sensor packages are received at the differential amplifier mounted on the carrier, which combines these output signals vectorially to generate at least one amplifier output which represents the electric current in the conductor but compensated to remove the effect of any background magnetic field which is common to the two hall sensor packages. Note that the magnetic field due to the current to be measured is in opposite directions at each of the hall sensor packages because these are located at opposite points across the conductor or at opposite faces, whereas any background field can be assumed to be in approximately the same direction and with approximately the same magnitude at both points, so that carrying out a vector subtraction of the two measured fields yields an output proportional to the current to be measured which is already compensated to remove the background magnetic field.

At step 140 the amplifier output is output from the sensor, for example via the electrical connector for further use, which may involve further conditioning or compensation steps and analogue to digital conversion.

At step 150 the conditioned and digitized amplifier output is then used as a measure of current in the conductor for example to provide control of the current or other uses. In the context of the electric vehicle application of figure 1 this may involve providing the measurement to the battery management system 24, the power train electronic control unit 26, or elsewhere.

Although particular embodiments have been described in detail, the skilled person will appreciate that various modifications and changes may be made to these without departing from the scope of the invention. For example, although the sensor 30 has largely been described in the context of measuring motive electrical current within a powertrain of an electric vehicle, it may be used in a variety of other contexts and applications where current within a conductor is to be measured.

For example, the sensor has been described as suitable for measuring electric current in a conductor with opposing, for example parallel and flat opposing faces, for example where the conductor is of rectangular or similar form. However, the invention may also be applied to measuring electric current in conductors of other cross sectional shapes such as of circular, oval or more complex cross sections, where two hall effect packages are disposed at opposing sides, faces or points of the conductor, or indeed where three or more such packages are used and disposed in such a manner that a suitable vector combination of the detected fields tends to cancel any background field common to all of the hall effect packages.

Although the sensor 30 has been described as deployed at an electrical conductor within which the current to be measured is flowing, embodiments of the invention also relate to the sensor as such, for example before any such installation or deployment has taken place.

Embodiments of the present invention are set out in the following clauses:
Clause A1. An electrically powered vehicle comprising:
   an electrical conductor arranged to carry motive electric current for powering movement of the vehicle, the electrical conductor having opposing faces; and
   a current sensor arranged to measure the motive electric current in the electrical conductor, the current sensor comprising:
      a carrier extending around the conductor so as to be in confrontation with both of the opposing faces;
      first and second hall sensor packages mounted on the carrier at the opposing faces of the conductor, each hall sensor package being arranged to output a signal representative of a magnetic field at the package;
      a differential amplifier mounted on the carrier, the differential amplifier being arranged to receive the signals from the first and second hall sensor packages and to combine the signals to provide at least one amplifier output representing the motive electrical current.
Clause A2. The electrically powered vehicle of clause A1, wherein the carrier comprises a flexible printed circuit board (flexible PCB), and the first and second hall sensor packages and the differential amplifier are mounted on, and in electrical communication with each other via, the flexible PCB.
Clause A3. The electrically powered vehicle of clause A2, wherein the carrier further comprises at least first and second stiffener elements, each stiffener element being disposed between a respective one of the faces of the conductor and an adjacent portion of the flexible PCB.
Clause A4. The electrically powered vehicle of any of clauses A1 to A3 wherein each hall sensor package is arranged to detect the magnetic field parallel to the adjacent face of the conductor which is caused by the motive current flowing in the conductor.
Clause A5. The electrically powered vehicle of any of clauses A1 to A4 wherein the first and second hall sensor packages are mounted on respective first and second planar regions of the carrier, and the first and second planar regions are coupled by a bend region of the carrier.
Clause A6. The electrically powered vehicle of clause A5 wherein the carrier further comprises a connection region extending from one of the first and second planar regions, and an electrical connector mounted on a distal end of the connection region, the connection region carrying the at least one amplifier output to the electrical connector for output from the sensor.
Clause A7. The electrically powered vehicle of any of clauses A1 to A6 wherein the electrical conductor one or more of: has a cross sectional area at the current sensor of from 50 mm² to about 1000 mm²; and has a cross section aspect ratio of the lengths of the opposing faces and the spacing between the opposing faces of between 2 and 20.
Clause A8. The electrically powered vehicle of any of clauses A1 to A7 wherein there is no aperture through the electrical conductor between the portions of the carrier extending around the conductor, or through the electrical conductor between the first and second hall sensor packages.
Clause A9. The electrically powered vehicle of any of clauses A1 to A8 wherein the sensor does not comprise any magnetic flux concentrator component adjacent to the electrical conductor.
Clause A10. The electrically powered vehicle of any of clause A1 to A9 wherein the vehicle is arranged to control the motive electrical current responsive to the at least one amplifier output.
Clause B11. A current sensor for measuring electric current in an electrical conductor having opposing faces, the current sensor comprising:
   a flexible carrier having first and second planar regions, the flexible carrier being arranged to extend around the conductor so that the first and second planar regions are in confrontation with the respective opposing faces;
   first and second hall sensor packages mounted on the carrier in the respective first and second planar regions, each hall sensor package being arranged to output a signal representative of a magnetic field at that hall sensor package; and
   a differential amplifier mounted on the carrier, the differential amplifier being arranged to receive the signals from the first and second hall sensor packages and to combine the signals to provide at least one amplifier output representing the electric current.
Clause B12. The current sensor of clause B11 wherein the flexible carrier further comprises a bend region connecting the first and second planar regions.
Clause B13. The current sensor of clause B11 or B12 wherein the flexible carrier further comprises a connection region connecting either the first or the second planar region to an electrical connector arranged to output the at least one amplifier output representing the electrical current.
Clause B14. The current sensor of clause B13 wherein the flexible carrier comprises a flexible printed circuit board, PCB, and wherein the first and second hall sensor packages, the differential amplifier, and the electrical connector are in electrical communication via tracks of the flexible PCB.
Clause B15. The current sensor of any of clauses B11 to B14 further comprising stiffener elements coupled to the flexible PCB in each of the first and second planar regions.
Clause C16. An electric vehicle comprising:
   an electrical conductor arranged to carry electric current within a powertrain of the electric vehicle; and
   the current sensor of any of clauses B11 to B15 arranged to measure the electric current in the electrical conductor.
Clause D17. A method of measuring the electric current in an electrical conductor having opposing faces, the method comprising:
   bending or wrapping a flexible carrier on which first and second hall sensor packages are mounted around the conductor so that each hall sensor package is adjacent to a different one of the opposing faces and provides an output signal representing the local magnetic field arising from the electric current;
   receiving the output signals at a differential amplifier mounted on the carrier, the differential amplifier being arranged to combine the output signals to generate at least one amplifier output which represents the electric current compensated to remove the effect of background magnetic field common to the two hall sensor packages; and
   outputting the amplifier output from the sensor.
Clause D18. The method of clause D17 wherein the flexible carrier comprises a flexible PCB on which the hall sensor packages and the differential amplifier are mounted.
Clause D19. The method of clause D17 or D18 wherein the electrical conductor is arranged to carry motive electric current within the powertrain of an electric vehicle.
Clause D20. The method of any of clauses D17 to D19 wherein one or more of: there is no aperture through the electrical conductor adjacent to the first and second hall sensor packages; and there is no magnetic flux concentrator component adjacent to the first and second hall sensor packages.

## Claims

1. An electrically powered vehicle comprising:
an electrical conductor arranged to carry motive electric current for powering movement of the vehicle, the electrical conductor having opposing faces; and
a current sensor arranged to measure the motive electric current in the electrical conductor, the current sensor comprising:
a carrier extending around the conductor so as to be in confrontation with both of the opposing faces;
first and second hall sensor packages mounted on the carrier at the opposing faces of the conductor, each hall sensor package being arranged to output a signal representative of a magnetic field at the package;
a differential amplifier mounted on the carrier, the differential amplifier being arranged to receive the signals from the first and second hall sensor packages and to combine the signals to provide at least one amplifier output representing the motive electrical current.

2. The electrically powered vehicle of claim 1, wherein the carrier comprises a flexible printed circuit board (flexible PCB), and the first and second hall sensor packages and the differential amplifier are mounted on, and in electrical communication with each other via, the flexible PCB, and
optionally, wherein the carrier further comprises at least first and second stiffener elements, each stiffener element being disposed between a respective one of the faces of the conductor and an adjacent portion of the flexible PCB.

3. The electrically powered vehicle of any preceding claim wherein each hall sensor package is arranged to detect the magnetic field parallel to the adjacent face of the conductor which is caused by the motive current flowing in the conductor.

4. The electrically powered vehicle of any preceding claim wherein the first and second hall sensor packages are mounted on respective first and second planar regions of the carrier, and the first and second planar regions are coupled by a bend region of the carrier, and
optionally, wherein the carrier further comprises a connection region extending from one of the first and second planar regions, and an electrical connector mounted on a distal end of the connection region, the connection region carrying the at least one amplifier output to the electrical connector for output from the sensor.

5. The electrically powered vehicle of any preceding claim wherein the electrical conductor one or more of: has a cross sectional area at the current sensor of from 50 mm² to about 1000 mm²; and has a cross section aspect ratio of the lengths of the opposing faces and the spacing between the opposing faces of between 2 and 20.

6. The electrically powered vehicle of any preceding claim wherein there is no aperture through the electrical conductor between the portions of the carrier extending around the conductor, or through the electrical conductor between the first and second hall sensor packages, and/or
wherein the sensor does not comprise any magnetic flux concentrator component adjacent to the electrical conductor.

7. The electrically powered vehicle of any preceding claim wherein the vehicle is arranged to control the motive electrical current responsive to the at least one amplifier output.

8. A current sensor for measuring electric current in an electrical conductor having opposing faces, the current sensor comprising:
a flexible carrier having first and second planar regions and a bend region connecting the first and second planar regions, the flexible carrier being arranged to extend around the conductor so that the first and second planar regions are in confrontation with the respective opposing faces;
first and second hall sensor packages mounted on the carrier in the respective first and second planar regions, each hall sensor package being arranged to output a signal representative of a magnetic field at that hall sensor package; and
a differential amplifier mounted on the carrier, the differential amplifier being arranged to receive the signals from the first and second hall sensor packages and to combine the signals to provide at least one amplifier output representing the electric current.

9. The current sensor of claim 8 wherein the flexible carrier further comprises a connection region connecting either the first or the second planar region to an electrical connector arranged to output the at least one amplifier output representing the electrical current, and
optionally, wherein the flexible carrier comprises a flexible printed circuit board, PCB, and wherein the first and second hall sensor packages, the differential amplifier, and the electrical connector are in electrical communication via tracks of the flexible PCB.

10. The current sensor of claim 8 or 9 further comprising stiffener elements coupled to the flexible PCB in each of the first and second planar regions.

11. An electric vehicle comprising:
an electrical conductor arranged to carry electric current within a powertrain of the electric vehicle; and
the current sensor of any of claims 8 to 10 arranged to measure the electric current in the electrical conductor.

12. A method of measuring the electric current in an electrical conductor having opposing faces, the method comprising:
bending or wrapping a flexible carrier on which first and second hall sensor packages are mounted around the conductor so that each hall sensor package is adjacent to a different one of the opposing faces and provides an output signal representing the local magnetic field arising from the electric current;
receiving the output signals at a differential amplifier mounted on the carrier, the differential amplifier being arranged to combine the output signals to generate at least one amplifier output which represents the electric current compensated to remove the effect of background magnetic field common to the two hall sensor packages; and
outputting the amplifier output from the sensor.

13. The method of claim 12 wherein the flexible carrier comprises a flexible PCB on which the hall sensor packages and the differential amplifier are mounted.

14. The method of claim 12 or 13 wherein the electrical conductor is arranged to carry motive electric current within the powertrain of an electric vehicle.

15. The method of any of claims 12 to 14 wherein one or more of: there is no aperture through the electrical conductor adjacent to the first and second hall sensor packages; and there is no magnetic flux concentrator component adjacent to the first and second hall sensor packages.
